# EUROPEAN PATENT SPECIFICATION

(11) **EP 0 734 052 B1**
(45) Date of publication and mention of the grant of the patent: **15.04.1998**
(21) Application number: 95305847.6
(22) Date of filing: 22.08.1995
(51) Int. Cl.: H01L 21/00

(54) **Improvements in or relating to electrostatic holding systems for holding substrates in processing chambers**
Verbesserung für elektrostatische Spannvorrichtung um einen Substrat in einem Behandlungskammer zu halten
Amélioration pour mandrin électrostatique pour tenir un substrat dans une chambre de traitement

(30) Priority: 24.03.1995 US 410449
(43) Date of publication of application: 25.09.1996
(73) Proprietor: APPLIED MATERIALS, INC., Santa Clara, California 95054-3299 (US)
(72) Inventor: Shamouillian, Shamouil, San Jose, California 95120 (US); Goldspiel, Alan, Watsonville, Ca 95076 (US); Birang, Manoocher, Los Gatos, CA 95030 (US); Northrup, Ron, San Jose, CA 95124 (US); Cameron, John F., Los Altos, CA 94022 (US); Sherstinsky, Semyon, San Francisco, CA 94121 (US); Deshpandey, Chandra, Fremont, CA 94539 (US); Somekh, Sasson, Los Altos Hills, CA 94022 (US)
(74) Representative: Bayliss, Geoffrey Cyril

(56) References cited:
- EP-A- 0 552 877
- US-A- 4 520 421
- US-A- 5 250 137
- US-A- 5 460 684

## Description

This invention relates to electrostatic chucks used for holding substrates in process chambers.

Electrostatic holding systems comprising electrostatic chucks are used to hold semiconductor substrates, such as a silicon wafers, during processing of the substrates. A typical electrostatic chuck includes an electrostatic member on a base, the base capable of being secured to a support in a process chamber. Typically, the electrostatic member has coolant grooves for holding a coolant for cooling the substrate. To use the chuck, a substrate is placed on the electrostatic member, and the electrostatic member is electrically biased with respect to the substrate by an electrical voltage. Process gas is introduced into the process chamber, and in certain processes, a plasma is formed from the process gas. Opposing electrostatic charge accumulates in the electrostatic member and substrate, resulting in an attractive electrostatic force that electrostatically holds the substrate to the chuck. The electrostatically held substrate covers and seals the coolant grooves in the chuck so that coolant substantially does not leak out from the grooves.

Conventional electrostatic chucks have certain limitations. Monopolar chucks that have a single monopolar electrode can electrostatically hold a substrate only during the plasma stages of the process. Typically, a positive potential is applied to the monopolar electrode on the chuck, and the substrate is maintained at a negative potential by charges plasma species in the chamber, causing electrostatic charge to electrostatically hold the substrate to the chuck. However, during the non-plasma stages of the process, the substrate is not securely held to the chuck and can move or become misaligned, and/or ineffectively seal the grooves on the chuck causing coolant to leak out.

US-A-4,520,421 discloses a semi-conductor fabricating apparatus having a monopolar electrostatic holding system for wafers to be processed. Wafers are supported on a base which carries target attracting portions of semi-conductive dielectric material with electrodes on their under sides. A wafer is disposed on the upper side of the specimen attracting portions and a common voltage is applied to the specimen attracting portions from a power supply to generate a dielectric flux between the specimen attracting portions through the wafer. As a result, an electrostatic attractive force is generated between the wafer and the specimen attracting portions to hold the wafer on the attracting portions.

Bipolar electrode chucks that have two or more electrodes can electrostatically hold a substrate for both plasma and non-plasma processes. Bipolar chucks are operated by applying a positive potential to one of the electrodes and a negative potential to the other electrode. However, when a bipolar chuck is used in a plasma process where charged plasma species impinge on the substrate, a complex circuit is necessary to balance the current flow in, and voltage applied to, each electrode. The complex circuit requires a floating power supply that allows the charged plasma species to maintain the substrate either at a negative potential of a few hundred volts or at electrical ground. The complex circuitry renders the chuck more costly to fabricate and maintain.

Conventional bipolar electrode chucks are also disadvantageous because the bipolar electrodes provide only about ¼ of the electrostatic clamping force provided by a monopolar electrode having the same electrode area. Lower electrostatic force results because electrostatic clamping force is proportional to the square of the electrode area; and each bipolar electrode has only half the area of a single monopolar electrode. Maximizing electrostatic clamping force is beneficial to reduce movement of the substrate during processing which can result in loss of the entire substrate. Also, higher clamping force allows coolant at higher pressures to be held in the cooling grooves without escaping, thereby allowing better control of the substrate temperature.

An object of the present invention is to provide an electrostatic chuck than can be used for both non-plasma and plasma processes without use of complex circuitry, and which allows maximization of the electrostatic clamping force for different process stages.

This invention provides an electrostatic holding system for holding a substrate in a process chamber having a voltage supply, the holding system comprising an electrostatic member and at least a pair of electrodes connected to the voltage supply for holding a substrate to the electrostatic member, the holding system including a switch electrically connecting the electrodes to the voltage supply and having a monopolar position for providing a voltage having a potential to the electrodes for operating the electrodes as monopolar electrodes to hold electrostatically the substrate to the electrostatic member with a relatively high force; wherein the switch also has a bipolar position for providing a voltage having opposing potentials to the electrodes for operating the electrodes as bipolar electrodes to hold electrostatically the substrate to the electrostatic member with a relatively low force.

The switch may also comprise an open circuit position for connecting the electrodes to an open circuit.

In one arrangement according to the invention the voltage supply in the process chamber comprises a single voltage source, the switch in the monopolar mode electrically connecting the electrodes to the voltage source, and in the bipolar mode connecting at least one electrode to ground and another electrode to the voltage source.

More specifically the electrostatic member may be supported by a base, and the electrodes in the electrostatic member may be electrically connected to the voltage supply in the chamber via electrical connectors disposed through the base so that when a substrate is held on the electrostatic member, the electrical connectors are substantially covered by the substrate and thereby undergo reduced erosion, each electrode and electrical connector being fabricated from a unitary electrically conductive member.

This invention provides a method so as defined by the features of method claims 6 and 8 of using the electrostatic holding system of any of the above arrangements comprising the steps of placing a substrate on the electrostatic member, activating the switch to the monopolar position to electrostatically hold the substrate during a plasma process stage; and before or after the immediately preceding step, activating the switch to the bipolar position to electrostatically hold the substrate during a non-plasma process stage.

More particularly in the monopolar position, a first voltage is applied to the electrodes so that the electrostatic charges having substantially identical polarity accumulates in the electrodes, and in the bipolar position, a second voltage is applied to the electrodes so that electrostatic charges having opposing polarities accumulate in the electrodes.

The invention also provides a method of holding a substrate in a process chamber during a process comprising plasma and non-plasma stages, the method comprising the steps of securing an electrostatic member comprising at least two electrodes in the process chamber, placing a substrate on the electrostatic member, electrostatically holding the substrate to the electrostatic member during a plasma process stage by applying a first voltage to the electrodes to operate the electrodes as monopolar electrodes, and before or after the immediately preceding step electrostatically holding the substrate to the electrostatic member during a non-plasma process stage by applying a second voltage to the electrodes to operate the electrodes as bipolar electrodes.

These and other features, aspects, and advantages of the present invention will become better understood with regard to the following description, appended claims, and accompanying drawings.

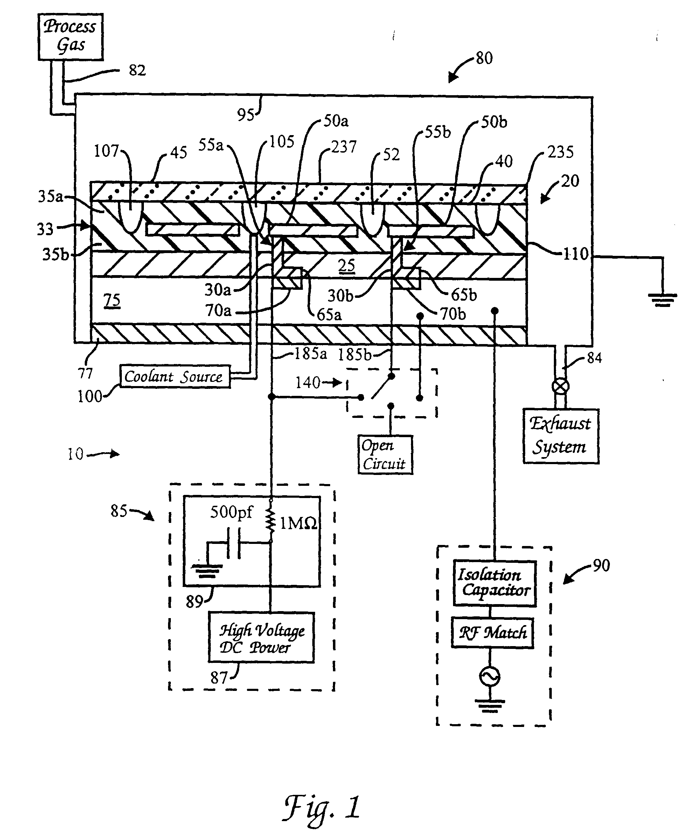

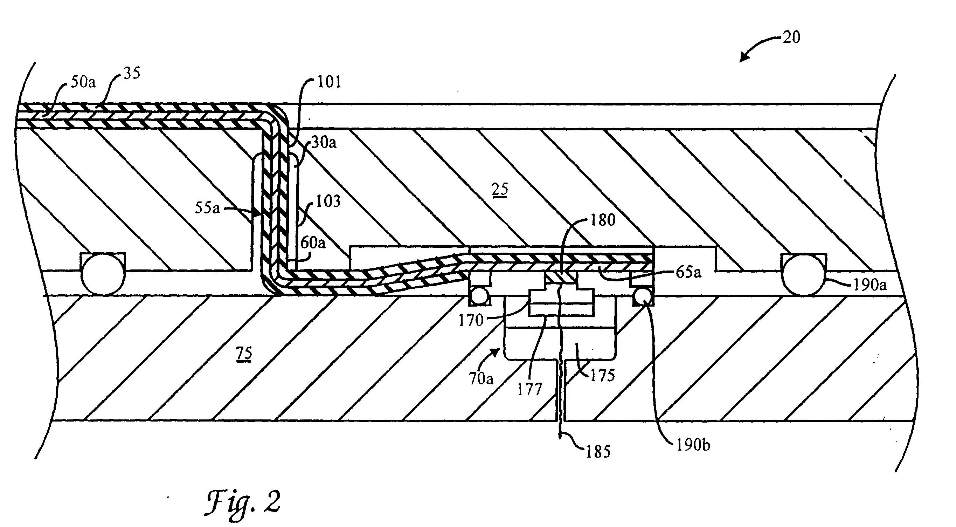

Operation of an electrostatic holding system **10** comprising an electrostatic chuck **20** according to the present invention is illustrated by the example shown in Figure 1. The electrostatic chuck **20** comprises a base **25** with bores **30a**, **30b** therethrough. An electrostatic member **33** having at least two electrodes **50a**, **50b** therein, is supported by the base **25**. Typically, the electrostatic member **33** comprises an insulator **35** having (i) a lower insulative layer **35a** and an upper insulative layer **35b** enclosing the electrodes **50a**, **50b**, and (ii) an upper surface **40** for receiving a substrate **45** thereon. Electrical connectors **55a**, **55b** comprising electrical leads **60a**, **60b** extend through the bores **30a**, **30b** of the base **25** and end in electrical contacts **65a**, **65b** to electrically connect the electrodes to the voltage supply terminals **70a**, **70b**, respectively, as shown in Figure 2. During its use, the electrostatic chuck **20** is secured on a support **75** in a process chamber **80**. The process chamber **80** includes an electrically grounded surface **95** which forms an enclosure for plasma processing of substrates **45**. The process chamber **80** typically includes a gas inlet **82** for introducing a plasma-forming process gas, and a throttled exhaust **84** for exhausting the reacted plasma and gas products from the process chamber **80**. The support **75** in the process chamber **80** has an insulator flange **77** disposed between the support **75** and the grounded surface **95** to electrically isolate the support from the grounded surface **95.** The particular embodiment of the process chamber **80** shown in Figure 1 is suitable for plasma processing of substrates **45**, the plasma being a primary source of erosion of the chuck **20**. However, the present invention can be used with other process chambers and other processes without deviating from the scope of the invention.

To operate the chuck **20**, the chuck **20** is secured on the support **75** so that the electrical contacts **65a**, **65b** of the chuck **20** electrically engage the voltage supply terminals **70a**, **70b** on the support **75**. The process chamber **80** is evacuated and maintained at a predetermined pressure. A substrate **45** is then placed on the chuck **20**, and the electrodes **50a**, **50b** of the chuck **20** are activated using the first voltage supply **85** to hold the substrate **45** to the chuck **20**. Thereafter the process gas is introduced into the chamber **80** via the gas inlet **82**, and a plasma is formed for certain stages of the process, by activating the second voltage supply **90**.

The electrostatic holding system **10** of the present invention allows use of the chuck **20** in processes having both plasma and non-plasma stages. A switching system uses a switch **140** to operate the electrodes **50a**, **50b** as monopolar electrodes during plasma stages, and bipolar electrodes during non-plasma stages. The switch **140** has three positions, namely (i) a monopolar position, (ii) a bipolar position, and (iii) an open circuit position. In the monopolar position, the switch connects both electrodes **50a**, **50b** to the first voltage supply **85**, thereby maintaining both electrodes **50a**, **50b** at the same electrical potential, so that the electrodes serve as a unitary monopolar electrode. Simultaneously, the second voltage supply **90** is activated to electrically bias the support **75** to form a plasma in the chamber **80**. The electrically charged species of the plasma impinge on the substrate **45** and maintain the substrate **45** at an opposing electrical potential to that of the electrodes **50a**, **50b**. The opposing electrical potential cause opposing electrostatic charge to accumulate in the substrate **45** and in the electrodes **50a**, **50b**, thereby resulting in an attractive electrostatic force which holds the substrate **45** to the chuck **20**.

In the bipolar position, the switch **140** connects the first electrode **50a** to the first voltage supply **85** to maintain the electrode at a first electrical potential, and connects the second electrode **50b** to the support **75**. Typically, during bipolar operation, the second voltage supply **90** is deactivated, and the support **75** is electrically grounded. For example, the first electrode **50a** is maintained at a positive potential by the voltage supply **85**, and the second electrode **50b** is maintained at an opposing electrical potential, namely electrical ground. In his manner, the switchable system allows the electrodes **50a**, **50b** to be maintained at opposing electrical potentials during the non-plasma stages of the process to operate the electrodes **50a**, **50b** as bipolar electrodes.

The open circuit position of the switch **140** is used to transition the electrodes **50a**, **50b** between the monopolar and bipolar operational modes. When the process is transitioned from a plasma to a non-plasma stage, the plasma in the chamber **80** cannot be instantaneously evacuated, and some residual electrical charged plasma species remain in the chamber **80** for a short period after, the second voltage supply **90** is turned off. Thus, in between the plasma and non-plasma process stages, the switch **140** is set to the open circuit position, in which no electrical potential is maintained in the electrodes **50a**, **50b**. The open circuit position delays or stabilizes the transition between the monopolar and bipolar operational modes of the electrodes **50a**, **50b**.

Typically, the first voltage supply **85** includes a high voltage DC power supply **87** and an alternating current filter **89**. Typically, the DC power supply **87** provides a DC voltage ranging from about 1000 to 3000 volts, and more preferably from about 2000 volts. A suitable first voltage supply **85** typically includes a circuit which comprises a DC power supply of about 1000 to 3000 volts, connected to a high voltage readout, through a 10 MΩ resistor. A 1 MΩ resistor in the circuit limits current flowing through the circuit, and a 500 pF capacitor is provided as an alternating current filter.

The second voltage supply **90** is connected to the support **75** in the process chamber **80**. At least a portion of the support **75** is typically electrically conductive and functions as a process electrode, or cathode, for forming a plasma in the chamber **80**. The second voltage supply **90** is provided for electrically biasing the support **75** with respect to the electrically grounded surface **95** in the chamber **80**, to form a plasma from process gas introduced into the chamber **80**. The second voltage supply **90** generally comprises an RF impedance that matches the impedance of the process chamber **80** to the impedance of the line voltage, in series with an isolation capacitor.

The switchable system is advantageous for processes which comprise both plasma and non-plasma stages. During the non-plasma stage of the process, such as when the substrate **45** is being heated to process temperatures, the switchable system allows the electrostatic chuck **20** to be used in a bipolar mode, with one electrode **50a** electrically charged and the other electrode **50b** electrically grounded, to electrostatically hold the substrate **45** without use of a plasma. During the plasma stage of the process, the switchable system allows the chuck **20** to be operated in a monopolar mode, which provides increased electrostatic clamping force to prevent movement or misalignment of the substrate **45**.

During operation of the chuck, the substrate **45** held on the chuck **20** is cooled using a coolant source **100** that supplies coolant to cooling grooves **105** in the upper surface **40** of the insulator **35**. The substrate **45** held on the chuck **20** covers and seals the grooves **105** preventing leaking of coolant. The coolant in the grooves **105** removes heat from the substrate **45** and maintains the substrate **45** at constant temperatures during processing of the substrate. Typically, the cooling grooves **105** on the insulator **35** are spaced apart, sized, and distributed so that coolant held in the grooves **105** can cool substantially the entire substrate **45**. Typically, the grooves **105** form a pattern of intersecting channels that extend through the entire insulator **35** and electrodes **50a**, **50b**. More preferably, the cooling grooves **105** are formed in the electrical isolation voids **52** between the first and second electrodes **50a**, **50b**, that electrically isolate the electrodes from one another, to maintain the electrodes at opposing electrostatic polarities. Preferably, the electrodes **50a**, **50b** and the electrical isolation voids **52** therebetween are sized and configured so that the electrical isolation voids **52** can serve as cooling grooves **105** for holding coolant for cooling the substrate **45** on the chuck **20**.

Particular aspects of the chuck **20** will now be discussed.

The base **25** of the chuck **20** supports the electrostatic member **33**, and typically is shaped and sized to correspond to the shape and size of the substrate **45** to maximize heat transfer and provide a wide holding surface. For example, if the substrate **45** is disk shaped, a right cylindrically shaped base **25** is preferred. Typically, the base **25** is of aluminum and has a cylindrical shape with a diameter of about 100 mm to 225 mm, and a thickness of about 1.5 cm to 2 cm. The top and bottom surfaces of the plate are ground using conventional grinding techniques, until the surface roughness of the plate is less than 1 micron, so that the base **25** can uniformly contact the support **75** and the substrate **45**, to allow efficient thermal transfer between the substrate **45** and the support **75**. After grinding, the plate is thoroughly cleaned to remove grinding debris.

The base **25** has bores **30a**, **30b** therethrough, each bore having a slot portion **101** and an enlarged counterbore portion **103** extending from the slot portion **101**, as shown in Figure 2. The bores **30a**, **30b** are sized sufficiently large to insert the electrical leads **60a**, **60b** or the electrical lead **60** and integral electrical contacts **65a**, **65b** therethrough with minimal or substantially no clearance. Preferably, the bores **30a**, **30b** are sized sufficiently small that when the electrical leads of the connectors **55** are within the bores **30a**, **30b**, substantially no gas leaks from the bores, a suitable clearance being less than about 5 mm.

The electrostatic member **33** comprises an insulator **35** with electrodes **50a**, **50b** therein. The insulator **35** typically comprises an electrically insulative polymeric material, such as polyimide, polyketone, polyetherketone, polysulfone, polycarbonate, polystyrene, nylon, polyvinylchloride, polypropylene, polyetherketones, polyethersulfone, polyethylene terephthalate, fluoroethylene propylene copolymers, cellulose, triacetates, silicone, and rubber. Preferably, the insulator **35** is resistant to temperatures in excess of 50°C, and more preferably in excess of 100°C, so that the chuck **20** can be used for high temperature processes. Also, preferably, the insulator **35** has a high thermal conductivity so that heat generated in the substrate **45** during processing can dissipate through the chuck **20**, a suitable thermal conductivity being at least about 0.10 Watts/m/K. The insulator **35** can also have dispersed therein a high thermal conductivity powder filler material, such as diamond, alumina, zirconium boride, boron nitride, and aluminum nitride, having an average particle size of less than about 10 µm, to increase the thermal conductivity and erosion resistance. Preferably, the volumetric ratio of the filler to insulator is from about 10% to 80%, and more typically from 20% to 50%. Additionally, a protective coating (not shown) can be applied on the upper surface **40** of the insulator **35** to protect the insulator **35** from chemical degradation when the chuck **20** is used in corrosive and erosive processing environments.

The insulator **35** is sized sufficiently large to enclose the electrodes **50a**, **50b** therein. Typically, the insulator **35** has a resistivity ranging from about 10¹³ Ω cm to 10²⁰ Ω cm, and a dielectric constant of at least about 2, and more preferably at least about 3. The overall thickness of the insulator **35** depends on the electrical resistivity and dielectric constant of the insulative material used to form the insulator **35**. For example, when the insulator **35** has a dielectric constant of about 3.5, the thickness of the insulator **35** is typically about 10 µm to about 500 µm thick, and more preferably from about 100 µm to about 300 µm thick. Polyimide insulative materials have dielectric breakdown strengths of typically at least about 100 volts/mil (3.9 volts/micron), and more typically at least about 1000 volts/mil (39 volts/micron). Typically, the insulator **35** comprises a two layer laminate structure, as illustrated in Figure 1, comprising a lower insulative layer **35a** and an upper insulative layer **35b**, between which the electrodes are embedded. Preferably, the insulative layers **35a**, **35b** have substantially equivalent thicknesses of from about 50 µm to about 60 µm thick.

The electrodes **50a**, **50b** are made from an electrically conductive material, such as for example, metals such as copper, nickel, chromium, aluminum, iron, and alloys thereof. The shape, size and number of the electrodes **50a**, **50b** are selected to maximize the area of the electrodes in contact with the substrate **45**. For example, the electrodes **50a**, **50b** are disk shaped for disk shaped substrates **45**. Preferably, the electrodes **50a**, **50b** cover substantially the entire area in the insulator **35**, the total area of the electrodes **50a**, **50b** being typically from about 50 to about 500 sq. cm., and more typically from 80 to 380 sq. cm. Preferably, the area of each of the two electrodes **50a**, **50b** is substantially equivalent and typically comprises about one-half of the total area of the top surface of the chuck **20**. Thus, for two electrodes, the area of each electrode **50a**, **50b** is preferably from about 50 to about 250 sq. cm., and more preferably from 100 to 200 sq. cm. Typically, the thickness of the electrodes **50** is from about 1 µm to 100 µm, and more typically is from about 1 µm to 50 µm. However, in certain bipolar configurations, it is advantageous to utilize thinner electrodes of less about 1 µm, and more preferably less than 0.5 µm thickness, to seal the tips **107** of the cooling grooves **105** at the peripheral edge **110** of the insulator **35**.

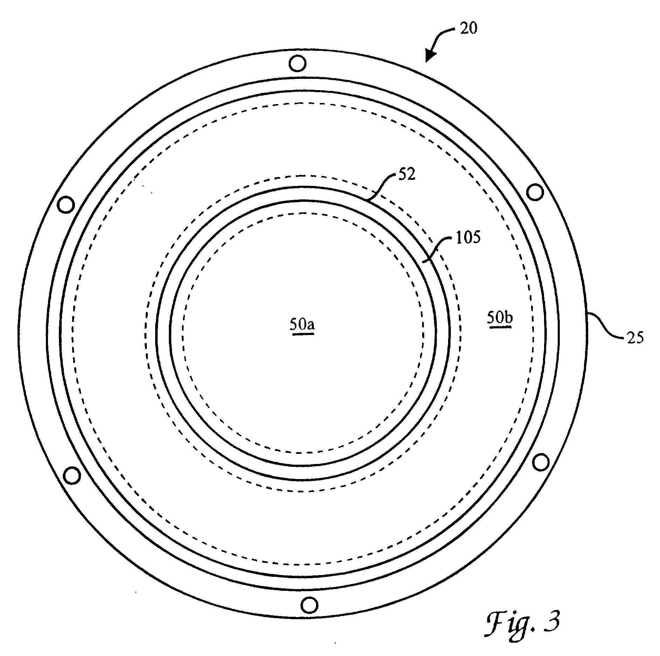

The electrodes **50a**, **50b** can either be continuous or patterned with interconnected features, the features sized so that cooling grooves **105** can be formed between the features for holding a coolant for cooling the substrate **45** held on the chuck **20**. The cooling grooves **105** can be formed in the isolation voids **52** between the electrodes, by cutting through the insulator **35** overlying the isolation void **52** so that the cooling grooves **105** extend through the insulator **35**, or the insulator can recede into the isolation voids **52** to form cooling grooves **105** lying between the electrodes **50a**, **50b**. This configuration allows utilization of the isolation voids **52** between the electrodes **50a**, **50b** to hold coolant without requiring additional grooves to be cut through the electrodes, thereby maximizing the effective electrostatic force of the electrodes **50a**, **50b**. For example, Figure 3 shows a double ring electrode configuration comprising an inner electrode ring **50a** and an outer electrode ring **50b**, with an electrical isolation void **52** therebetween. The electrical isolation void **52** between the two electrodes **50a**, **50b** is used to form a cooling groove **105**, allowing maximization of the electrode area. Preferably, the electrodes **50a**, **50b** are coplanar and have substantially equivalent areas so that the electrodes generate equivalent electrostatic clamping forces on the substrate **45**.

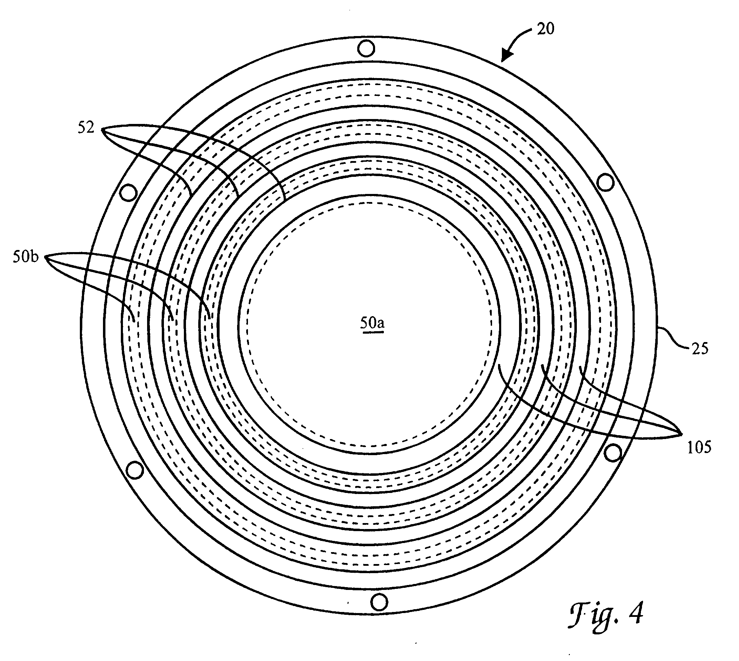

In a preferred configuration, the electrodes **50a**, **50b** and isolation voids **52** therebetween are sized and configured so that at least a portion of the electrical isolation voids **52** are positioned at the peripheral edge **110** of the insulator **35** so that coolant held in the tips **107** of the cooling grooves **105** can cool a perimeter **235** of the substrate **45** held on the chuck **20**. For example, in the electrode configuration shown in Figure **4**, the electrodes **50a**, **50b** are shaped and sized to form electrical isolation voids **52** comprising ring-shaped grooves which are arranged sufficiently close to the peripheral edge **110** of the insulator **35** that when the coolant is held in the grooves **105**, the coolant in the groove tips **107** cools the perimeter **235** of the substrate **45** without leaking out from the grooves **105**. In Figure 4, the first electrode **50b** comprises three outer ring electrodes and the second electrode **50a** comprises a single solid inner circle. When a substrate **45** is held on the chuck **20**, the substrate **45** presses against the ridges formed by the portions of the insulator **35** overlying the electrodes **50a**, **50b** and seals the coolant grooves **105** so that coolant does not leak out from the grooves **105.** Thus coolant can be distributed evenly and close to the perimeter **235** of the substrate **45** without leaking from the grooves **105**.

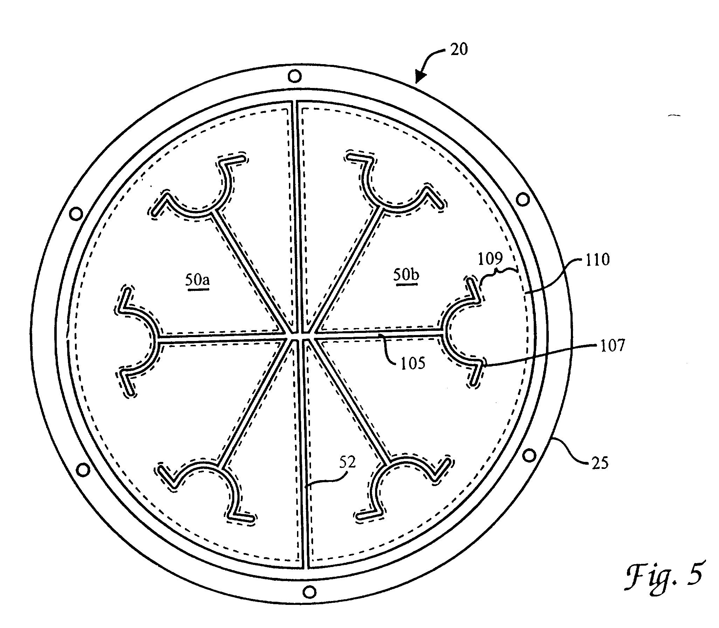

Another preferred configuration for the multi-electrode chuck **20** comprises two semicircular electrodes **50a**, **50b**, separated by at least one electrical isolation void **52** that extends radially across the insulator **35**, as illustrated by Figure 5. The radially extending isolation void **52** is used to form a cooling groove **105** which extends close to the peripheral edge **110** of the insulator **35**. The chuck **20** can also include additional radially extending cooling grooves **105** having groove tips **107** which extend close to the peripheral edge **110** of the insulator **35**. The groove tips **107** are positioned close to the peripheral edge **110** of the insulator **35** and define a gap **109** with the edge **110**. The coolant in the tips of the grooves **105** maintains the temperatures at the perimeter **235** of the substrate **45** substantially equivalent to the temperatures at the center **237** of the substrate **45**, the average difference in temperature between the perimeter **235** and center **237** of the substrate **45** being preferably less than about 10°C. Most preferably the coolant maintains substantially the entire substrate **45** at constant temperatures.

Two similar electrical connectors **55a**, **55b** are used to separately electrically connect each of the electrodes **50a**, **50b** to the first voltage supply **85**. The connectors are substantially identical and each comprise (i) electrical leads **60a**, **60b** that extend through a bore **30** in the base **25**, and (ii) electrical contacts **65a**, **65b**. The electrical leads **60a**, **60b** are fabricated from an electrically conductive metal such as copper or aluminum, the length of the electrical leads **60a**, **60b** being typically from 10 to 50 mm, and more typically from 20 to 40 mm. The width of the electrical leads **60a**, **60b** is typically from 2 to 10 mm, and more typically from 4 to 7 mm. Preferably, the electrical leads **60a**, **60b**, the electrodes **50a**, **50b** and the electrical contacts **65a**, **65b** are fabricated from a single unitary conductive member, such as a sheet of metal so that the electrical connector is an integral extension of the electrode. This version is advantageous because it is not necessary to fabricate or assemble a multicomponent assembly for contacting the voltage supply terminal. Typically, a continuous sheet of conductive metal is cut out to form the electrodes **50a**, **50b** and the electrical connector **55**. The electrical contacts **65a**, **65b** which are integral with the electrical leads **60a**, **60b** are shaped and sized sufficiently large to directly electrically engage the voltage supply terminals **70a**, **70b** on the support **75**, without causing arcing of the high voltage therethrough. Preferably, the area of the electrical contacts **65a**, **65b** integral with the leads **60a**, **60b** is at least about the area of the high voltage terminals **70a**, **70b**, and more preferably substantially equivalent to the area of the high voltage terminals **70a**, **70b**. Preferably, the area of each of the electrical contacts **65a**, **65b** is at least about 50 sq. mm, and more preferably at least about 100 sq. mm. Typically, the area of the electrical contacts **65a**, **65b** is from 50 to 400 sq. mm, and more typically from about 75 to 150 sq. mm. Typically, the electrical contacts **65a**, **65b** are disk-shaped and have a radii ranging from about 5 mm to about 12 mm to provide sufficient contact area.

A method of manufacturing the electrostatic member **33** will now be described. Preferably, the electrostatic member **33** is fabricated as a laminate comprising the insulator **35** with the electrodes **50a**, **50b** therein, and having electrical connectors **55a**, **55b** integral with the electrodes **50a**, **50b**. A suitable method of fabricating the laminate from a multi-layer film comprising an insulative layer and an electrically conductive layer, such as "R/FLEX 1100" film fabricated by Rogers Corporation, Chandler, Arizona, which comprises an electrically conductive copper layer on a 25 to 125 µm thick polyimide insulative layer. The copper layer of the multi-layer film is etched, routed, or milled to form the electrodes **50a**, **50b** and the integral electrical connectors **55a**, **55b**.

An etching process suitable for forming the electrodes **50a**, **50b** and integral electrical connectors **55a** and **55b** comprises the steps of (i) forming a protective resist layer patterned to correspond to the shape of the electrodes **50a**, **50b** and the electrical connectors **55a**, **55b**, over the electrically conductive layer of the multi-layer film, and (ii) etching the resist protected multi-layer film using conventional etching processes. The resist layer can be formed using photoresist materials, such as "RISTON" fabricated by DuPont de Nemours Chemical Co., Wilmington, Delaware, applied on the electrode layer. Conventional photolithographic methods, such as those described in Silicon Processing for the VLSI Era, Volume 1: Process Technology, Chapters 12, 13, and 14, by Stanley Wolf and Richard N. Tauber, Lattice Press, California (1986), which is incorporated herein by reference, can be used to pattern the resist layer on the electrically conductive layer. Conventional wet or dry chemical etching methods can be used to etch the multi-layer film. A suitable wet chemical etching method comprises immersing the multi-layer film into an etchant such as ferric chloride, sodium persulfate, or an acid or base, until the unprotected portion of the electrode layer is etched. Suitable dry etching processes are described in Silicon Processing, Chapter 16, supra, which is incorporated herein by reference.

After etching the electrically conductive layer to form the electrodes **50a**, **50b** and integral electrical connectors **55a**, **55b**; a second insulative film is adhered over the conductive layer so that the conductive layer is embedded within the insulator **35** to form the laminated electrostatic member **33**. Suitable insulative films include, for example, "KAPTON," a polyamide film manufactured by DuPont de Nemours Co., in Wilmington, Delaware; "APIQUEO" fabricated by Kanegafuchi Chemical Indus., Japan; "UPILEX" manufactured by Ube Indus. Ltd., Japan; "NITOMID" fabricated by Nitto Electric Indus. Co. Ltd., Japan; and "SUPERIOR FILM" fabricated by Mitsubishi Plastics Indus. Ltd., Japan.

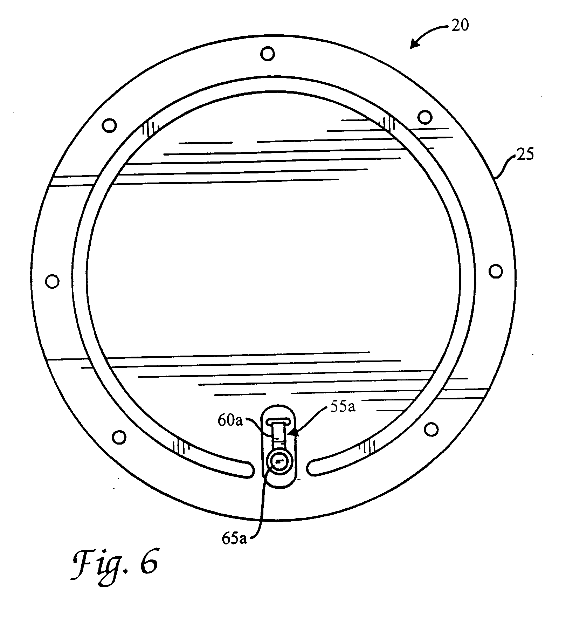

The electrostatic member laminate is cut to form the electrical connectors **55a**, **55b** that are each an integral extension of the electrodes **50a**, **50b**, by stamping, punching, or pressing out the electrical connectors **55a**, **55b** from the electrostatic member **33**. Preferably, the electrical connectors **55a**, **55b** are cut out so that the electrical leads **60a**, **60b** and electrical contacts **65a**, **65b** of the electrical connectors **55a**, **55b** are disposed within one of the patterned grooves **105**. Disposing the electrical connector within a segment of the grooves **105** allows fabrication of the electrodes **50a**, **50b**, the integral electrical connectors **55a**, **55b**, and the grooves **105** in a single step process. After cutting out the electrical connectors **55a**, **55b**, residual insulator on the electrical connectors **55a**, **55b** is removed by peeling off the insulator layer to expose the underlying electrically conductive layer to form the electrical contacts **65a** or **65b**. The insulated electrical leads **60a**, **60b** and electrical contacts **65a**, **65b** are then inserted through the bores in the base **25** so that the electrical contacts **65a**, **65b** are disposed below the base **25** as shown in Figure 6. The electrostatic member **33** is then adhered to the base **25** of the chuck **20**, using conventional pressure or temperature sensitive adhesives, such as polyimides. Thereafter, the electrical contacts **65a**, **65b** are adhered to the support member **75** on the base **25** of the chuck **20**.

### Voltage Supply Terminal

The voltage supply terminals **70a**, **70b** are located on the support **75** at the interface between the base **25** and the support **75**, as illustrated in Figure 2. Typically, each of the voltage supply terminals **70a**, **70b** includes a spring loaded right circular pin member **170** disposed in a bore **175** through the support **75**. The pin member **170** terminates in a conductive terminal **180** which is preferably gold-plated copper. A high voltage lead **185** extends from the first voltage supply **85** and through the pin member **170** to contact the conductive terminal **180**. A spring is disposed in the bore **175** of the support **7**5 in contact with the pin member **170** to bias the pin member **170** upwardly into contact with the electrical contacts **65a**, **65b** of the electrodes **50a**, **50b**.

The interface between the base **25** and the support **75** is sealed to prevent any coolant passing through the bores **30a**, **30b** of the base **25**, from leaking into the process chamber **80**. A sealing member comprising two sealing rings **190a**, **190b** is disposed in the interface between the base **25** and the support **75**. A first sealing ring **190a** is disposed below the base **25** circumferentially about both the electrical contacts **65a**, **65b** and the bores **30a**, **30b** of the base **25**. A second sealing ring **190b** is disposed circumferentially about the supply bore **175** of the support **75**, and in alignment with the electrical contacts **65a**, **65b**. Preferably, the two sealing rings **190a**, **190b** comprise O-ring seals.

The electrostatic chuck **20** having features of the present invention has several advantages. The electrostatic holding system **10** allows the chuck **20** to be used in both non-plasma or plasma processes, by operating the chuck **20** in a bipolar or monopolar mode. During the plasma stage of the process, the holding system **10** allows the chuck **20** to be operated in a monopolar mode, which provides increased electrostatic clamping force to prevent movement or misalignment of the substrate **45**. For these reasons, the chuck **20** of the present invention is a significant improvement over prior art chucks.

## Claims

1. An electrostatic holding system for holding a substrate (45) in a process chamber having a voltage supply (85), the holding system comprising an electrostatic member (35) and at least a pair of electrodes (50a,50b) connected to the voltage supply for holding a substrate to the electrostatic member, the holding system including a switch (140) electrically connecting the electrodes to the voltage supply and having a monopolar position for providing a voltage having a potential to the electrodes (50a,50b) for operating the electrodes as monopolar electrodes to hold electrostatically the substrate to the electrostatic member with a relatively high force; characterised in that the switch (140) also has a bipolar position for providing a voltage having opposing potentials to the electrodes for operating the electrodes as bipolar electrodes to hold electrostatically the substrate to the electrostatic member with a relatively low force.

2. An electrostatic holding system as claimed in claim 1, characterised in that the switch (140) further comprises an open circuit position for connecting the electrodes to an open circuit.

3. An electrostatic holding system as claimed in claim 1 or claim 2, characterised in that the voltage supply in the process chamber comprises a single voltage source (85), the switch in the monopolar mode electrically connecting the electrodes (50a,50b) to the voltage source, and in the bipolar mode connecting at least one electrode (50a) to ground (75) and another electrode (50b) to the voltage source.

4. An electrostatic holding system as claimed in any of claims 1 to 3, characterised in that the electrostatic member (35) is supported by a base (25), and the electrodes (50a,50b) in the electrostatic member are electrically connected to the voltage supply (85) in the chamber via electrical connectors (55a,55b) disposed through the base so that when a substrate is held on the electrostatic member, the electrical connectors are substantially covered by the substrate and thereby undergo reduced erosion, each electrode and electrical connector being fabricated from a unitary electrically conductive member.

5. An electrostatic holding system as claimed in any of claims 1 to 4, characterised in that the pair of electrodes (50a,50b) are electrically isolated from one another by an electrical isolation void (52), the electrodes being sized and configured so that the isolation void can form a cooling groove for holding coolant for cooling the substrate.

6. A method of using the electrostatic holding system of claim 1 comprising the steps of:
(a) placing a substrate on the electrostatic member;
(b) activating the switch to the monopolar position to electrostatically hold the substrate during a plasma process stage; and
(c) before or after step (b), activating the switch to the bipolar position to electrostatically hold the substrate during a non-plasma process stage.

7. A method of using the electrostatic holding system of claim 6, characterised in that in the monopolar position, a first voltage is applied to the electrodes so that the electrostatic charges having substantially identical polarity accumulate in the electrodes, and in the bipolar position, a second voltage is applied to the electrodes so that electrostatic charges having opposing polarities accumulate in the electrodes.

8. A method of holding a substrate in a process chamber during a process comprising plasma and non-plasma stages, the method comprising the steps of:
(a) securing an electrostatic member comprising at least two electrodes in the process chamber;
(b) placing a substrate on the electrostatic member;
(c) electrostatically holding the substrate to the electrostatic member with a relatively high force during a plasma process stage by applying a first voltage to the electrodes to operate the electrodes as monopolar electrodes; and
(d) before or after step (c), electrostatically holding the substrate to the electrostatic member with a relatively low force during a non-plasma process stage by applying a second voltage to the electrodes to operate the electrodes as bipolar electrodes.

9. A method as claimed in claim 8,
characterised in that the electrodes are connected to an open circuit position during the transition between the plasma and non-plasma stages of the process.

10. A method as claimed in claim 8,
characterised in that a three-position switch is connected to the electrodes, the switch having (i) a monopolar position for providing the first voltage to the electrodes, (ii) a bipolar position for providing the second voltage to the electrodes, and (iii) an open circuit position for connecting the electrodes to an open circuit.

11. A method as claimed in claim 8,
characterised in that the first electrical voltage comprises a direct current voltage of at least about 500 volts, and more preferably from about 500 to about 5000 volts.

12. A method as claimed in claim 8,
characterised in that the second electrical voltage comprises at least one of the following:
(i) a direct current voltage of at least about 500 volts applied to one of the electrodes, and electrical grounding of the second electrode; or
(ii) a direct current voltage having a first electrical potential applied to one electrode, and a direct current voltage having a second electrical potential applied to the other electrode.

## Patentansprüche

1. Elektrostatisches Haltesystem zum Halten eines Substrats (45) in einer Prozeßkammer mit einer Spannungsversorgung (85), wobei das Haltesystem ein elektrostatisches Element (35) und mindestens ein mit der Spannungsversorgung verbundenes Paar Elektroden (50a, 50b) zum Halten eines Substrats auf dem elektrostatischen Element aufweist, wobei das Haltesystem einen Schalter (140) aufweist, der die Elektroden elektrisch mit der Spannungsversorgung verbindet und eine monopolare Position hat zum Liefern einer Spannung mit einem Potential an die Elektroden (50a, 50b) zum Betreiben der Elektroden als monopolare Elektroden zum elektrostatischen Halten des Substrats auf dem elektrostatischen Element mit einer relativ hohen Kraft; dadurch gekennzeichnet, daß der Schalter (140) auch eine bipolare Position hat zum Liefern einer Spannung mit entgegengesetzten Potentialen an die Elektroden zum Betreiben der Elektroden als bipolare Elektroden zum elektrostatischen Halten des Substrats auf dem elektrostatischen Element mit einer relativ geringen Kraft.

2. Elektrostatisches Haltesystem nach Anspruch 1, dadurch gekennzeichnet, daß der Schalter (140) weiter eine offene Schaltungsposition zum Anschließen der Elektroden an eine offene Schaltung hat.

3. Elektrostatisches Haltesystem nach Anspruch 1 oder Anspruch 2, dadurch gekennzeichnet, daß die Spannungsversorgung in der Prozeßkammer eine einzige Spannungsquelle (85) aufweist, wobei der Schalter im monopolaren Betrieb die Elektroden (50a, 50b) elektrisch mit der Spannungsquelle verbindet und im bipolaren Betrieb mindestens eine Elektrode (50a) mit Masse (75) und eine weitere Elektrode (50b) mit der Spannungsquelle verbindet.

4. Elektrostatisches Haltesystem nach einem der Ansprüche 1 bis 3, dadurch gekennzeichnet, daß das elektrostatische Element (35) von einer Basis (25) getragen wird und die Elektroden (50a, 50b) im elektrostatischen Element elektrisch mit der Spannungsversorgung (85) in der Kammer über elektrische Verbindungen (55a, 55b) verbunden sind, die durch die Basis verlaufen, so daß bei einem Halten eines Substrats auf dem elektrostatischen Element die elektrischen Verbindungen im wesentlichen vom Substrat verdeckt werden und daher einer verringerten Erosion ausgesetzt sind, wobei jede Elektrode und elektrische Verbindung aus einem durchgehenden elektrisch leitfähigen Element hergestellt wird.

5. Elektrostatisches Haltesystem nach einem der Ansprüche 1 bis 4, dadurch gekennzeichnet, daß die beiden Elektroden (50a, 50b) durch einen elektrischen Isolationshohlraum (52) elektrisch voneinander isoliert sind, wobei die Elektroden so ausgelegt und angeordnet sind, daß der Isolationshohlraum eine Kühlrille zum Enthalten von Kühlmittel zum Kühlen des Substrats bilden kann.

6. Verfahren zum Verwenden des elektrostatischen Haltesystems nach Anspruch 1, mit den folgenden Schritten:
(a) Legen des Substrats auf das elektrostatische Element;
(b) Schalten des Schalters in die monopolare Position zum elektrostatischen Halten des Substrats während einer Plasmaprozeßstufe; und
(c) vor oder nach Schritt (b), Schalten des Schalters in die bipolare Position zum elektrostatischen Halten des Substrats während einer Nicht-Plasmaprozeßstufe.

7. Verfahren zum Verwenden des elektrostatischen Haltesystems nach Anspruch 6, dadurch gekennzeichnet, daß in der monopolaren Position eine erste Spannung so an die Elektroden angelegt wird, daß im wesentlichen identische Polarität aufweisende elektrostatische Ladungen in den Elektroden akkumuliert werden, und in der bipolaren Position eine zweite Spannung so an die Elektroden angelegt wird, daß im wesentlichen entgegengesetzte Polaritäten aufweisende Ladungen in den Elektroden akkumuliert werden.

8. Verfahren zum Halten eines Substrats in einer Prozeßkammer während eines Verfahrens, in dem Plasma- und Nicht-Plasmastufen verwendet werden, wobei das Verfahren die folgenden Schritte aufweist:
(a) Befestigen eines elektrostatischen Elements mit mindestens zwei Elektroden in der Prozeßkammer;
(b) Legen eines Substrats auf das elektrostatische Element;
(c) elektrostatisches Halten des Substrats auf dem elektrostatischen Element mit einer relativ großen Kraft während einer Plasmaprozeßstufe durch Anlegen einer ersten Spannung an die Elektroden zum Betreiben der Elektroden als monopolare Elektroden; und
(d) vor oder nach Schritt (c), elektrostatisches Halten des Substrats auf dem elektrostatischen Element mit einer relativ geringen Kraft während einer Nicht-Plasmaprozeßstufe durch Anlegen einer zweiten Spannung an die Elektroden zum Betreiben der Elektroden als bipolare Elektroden.

9. Verfahren nach Anspruch 8, dadurch gekennzeichnet, daß die Elektroden während des Übergangs zwischen der Plasma- und der Nicht-Plasmastufe des Verfahrens an eine offene Schaltungsposition angeschlossen sind.

10. Verfahren nach Anspruch 8, dadurch gekennzeichnet, daß ein Drei-Positions-Schalter an die Elektroden angeschlossen ist, wobei der Schalter (i) eine monopolare Position zum Liefern der ersten Spannung an die Elektroden, (ii) eine bipolare Position zum Liefern einer zweiten Spannung an die Elektroden und (iii) eine offene Schaltungsposition zum Verbinden der Elektroden an eine offene Schaltung hat.

11. Verfahren nach Anspruch 8, dadurch gekennzeichnet, daß die erste elektrische Spannung eine Gleichspannung von mindestens 500 V und noch besser zwischen 500 und 5000 V ist.

12. Verfahren nach Anspruch 8, dadurch gekennzeichnet, daß die zweite elektrische Spannung mindestens eine der folgenden ist:
(i) eine Gleichspannung von mindestens ungefähr 500 V, die an eine der Elektroden angelegt wird, bei elektrischem Erden der zweiten Elektrode; oder
(ii) eine Gleichspannung mit einem ersten an eine Elektrode angelegten elektrischen Potential und eine Gleichspannung mit einem zweiten an die andere Elektrode angelegten elektrischen Potential.

## Revendications

1. Système de maintien électrostatique destiné à maintenir un substrat (45) dans une chambre de traitement ayant une alimentation (85) en tension, le système de maintien comportant un élément électrostatique (35) et au moins deux électrodes (50a, 50b) connectées à l'alimentation en tension pour maintenir un substrat sur l'élément électrostatique, le système de maintien comprenant un commutateur (140) connectant électriquement les électrodes à l'alimentation en tension et ayant une position unipolaire pour appliquer une tension ayant un potentiel aux électrodes (50a, 50b) afin de faire fonctionner les électrodes en tant qu'électrodes unipolaires pour maintenir électrostatiquement le substrat sur l'élément électrostatique avec une force relativement élevée ; caractérisé en ce que le commutateur (140) possède également une position bipolaire pour appliquer aux électrodes une tension ayant des potentiels s'opposant afin de faire fonctionner les électrodes en tant qu'électrodes bipolaires pour maintenir électrostatiquement le substrat sur l'élément électrostatique avec une force relativement basse.

2. Système de maintien électrostatique selon la revendication 1, caractérisé en ce que le commutateur (140) possède en outre une position de circuit ouvert pour connecter les électrodes à un circuit ouvert.

3. Système de maintien électrostatique selon la revendication 1 ou la revendication 2, caractérisé en ce que l'alimentation en tension dans la chambre de traitement comprend une source de tension unique (85), le commutateur dans le mode unipolaire connectant électriquement les électrodes (50a, 50b) à la source de tension et, dans le mode bipolaire, connectant au moins une électrode (50a) à la masse (75) et une autre électrode (50b) à la source de tension.

4. Système de maintien électrostatique selon l'une quelconque des revendications 1 à 3, caractérisé en ce que l'élément électrostatique (35) est supporté par une embase (25), et les électrodes (50a, 50b) dans l'élément électrostatique sont connectées électriquement à l'alimentation (85) en tension dans la chambre par l'intermédiaire de connecteurs électriques (55a, 55b) disposés à travers l'embase afin que, lorsqu'un substrat est maintenu sur l'élément électrostatique, les connecteurs électriques soient sensiblement recouverts par le substrat et subissent ainsi une érosion réduite, chaque électrode et chaque connecteur électrique étant fabriqués à partir d'un élément électriquement conducteur d'un seul bloc.

5. Système de maintien électrostatique selon l'une quelconque des revendications 1 à 4, caractérisé en ce que deux électrodes (50a, 50b) sont isolées électriquement l'une de l'autre par un espace vide (52) d'isolement électrique, les électrodes étant dimensionnées et configurées pour que l'espace vide d'isolement puisse former une gorge de refroidissement destinée à contenir un fluide de refroidissement pour refroidir le substrat.

6. Procédé d'utilisation du système de maintien électrostatique selon la revendication 1, comprenant les étapes dans lesquelles :
(a) on place un substrat sur l'élément électrostatique ;
(b) on actionne le commutateur dans la position unipolaire pour maintenir électrostatiquement le substrat pendant une phase de traitement par plasma ; et
(c) avant ou après l'étape (b), on actionne le commutateur vers la position bipolaire pour maintenir électrostatiquement le substrat pendant une phase de traitement sans plasma.

7. Procédé d'utilisation du système de maintien électrostatique selon la revendication 6, caractérisé en ce que, dans la position unipolaire, une première tension est appliquée aux électrodes afin que les charges électrostatiques ayant une polarité sensiblement identique s'accumulent dans les électrodes et, dans la position bipolaire, une seconde tension est appliquée aux électrodes afin que des charges électrostatiques ayant des polarités s'opposant s'accumulent dans les électrodes.

8. Procédé de maintien d'un substrat dans une chambre de traitement pendant un traitement comprenant des phases avec plasma et sans plasma, le procédé comprenant les étapes dans lesquelles :
(a) on fixe un élément électrostatique, comportant au moins deux électrodes, dans la chambre de traitement ;
(b) on place un substrat sur l'élément électrostatique ;
(c) on maintient électrostatiquement le substrat sur l'élément électrostatique avec une force relativement élevée pendant une phase de traitement avec plasma en appliquant une première tension aux électrodes pour faire fonctionner les électrodes en tant qu'électrodes unipolaires ; et
(d) avant ou après l'étape (c), on maintient électrostatiquement le substrat sur l'élément électrostatique avec une force relativement basse durant une phase de traitement sans plasma en appliquant une seconde tension aux électrodes pour faire fonctionner les électrodes en tant qu'électrodes bipolaires.

9. Procédé selon la revendication 8,
caractérisé en ce que les électrodes sont connectées dans une position en circuit ouvert pendant la transition entre les phases avec plasma et sans plasma du traitement.

10. Procédé selon la revendication 8, caractérisé en ce qu'un commutateur à trois positions est connecté aux électrodes, le commutateur ayant (i) une position unipolaire pour appliquer la première tension aux électrodes, (ii) une position bipolaire pour appliquer la seconde tension aux électrodes, et (iii) une position en circuit ouvert pour connecter les électrodes à un circuit ouvert.

11. Procédé selon la revendication 8,
caractérisé en ce que la première tension électrique comprend une tension continue d'au moins environ 500 volts, et plus avantageusement d'environ 500 à environ 5000 volts.

12. Procédé selon la revendication 8,
caractérisé en ce que la seconde tension électrique comprend au moins l'une des suivantes :
(i) une tension continue d'au moins environ 500 volts appliquée à l'une des électrodes, et mise à la masse électrique de la seconde électrode ; ou
(ii) une tension continue ayant un premier potentiel électrique appliqué à une électrode, et une tension continue ayant un second potentiel électrique appliqué à l'autre électrode.
